# EUROPEAN PATENT APPLICATION

(11) **EP 4 438 961 A1**
(43) Date of publication of application: **02.10.2024**
(21) Application number: 23189651.5
(22) Date of filing: 04.08.2023
(51) Int. Cl.: F24F 1/022, F24F 13/22, F24F 13/24

(54) **LIQUID STORAGE CONTAINER AND MOBILE AIR CONDITIONER**

(30) Priority: 30.03.2023 CN 202310350399
(71) Applicant: Xiaomi Technology (Wuhan) Co., Ltd., Wuhan, Hubei 430000 (CN); Beijing Xiaomi Mobile Software Co., Ltd., Beijing 100085 (CN)
(72) Inventor: ZHANG, Huazhong, Wuhan, Hubei, 430000 (CN); CHEN, Gangping, Wuhan, Hubei, 430000 (CN); WU, Qingzhuang, Wuhan, Hubei, 430000 (CN); CHEN, Yongfeng, Wuhan, Hubei, 430000 (CN); LIU, Wuxiang, Wuhan, Hubei, 430000 (CN); XUE, Ziran, Wuhan, Hubei, 430000 (CN)
(74) Representative: Stöckeler, Ferdinand

(57) **Abstract**

A liquid storage container (100) includes a tank (1) and a flow guide part. The tank (1) has a liquid inlet (11) and a liquid outlet (12). The liquid inlet (11) is arranged at a top of the tank (1) and allows liquid to enter the tank (1), and the liquid outlet (12) is arranged at a bottom of the tank (1) and allows the liquid to be discharged from the tank (1). The flow guide part is arranged in the tank (1), and has a bottom end connected with a bottom wall of the tank (1) and a top end extending to the liquid inlet (11). A radial dimension of at least part of the flow guide part increases along a direction from the top end to the bottom end of the flow guide part (2).

## Description

### FIELD

The invention relates to the technical field of air conditioners, in particular to a liquid storage container for an air conditioner and a mobile air conditioner using the liquid storage container.

### BACKGROUND

Mobile air conditioners are common temperature regulating appliances in daily life, which are chosen by many consumers because of the small size and convenient movement. In order to realize the functions of cooling and heating, mobile air conditioners usually are provided with a built-in evaporator and a built-in condenser. During operation, the evaporator will absorb heat by evaporation, which will produce condensed water. In order to collect the condensed water, some mobile air conditioners are provided with a built-in water tank. However, the process of the condensed water flowing into the water tank will be accompanied by loud noise, which will cause troubles for users during lunch break or evening use.

### SUMMARY

The present invention aims at solving one of the technical problems in the related art at least to some extent.

Therefore, embodiments of the invention provide a liquid storage container, which can reduce an inflow noise of condensed water and other liquids and reduce an influence of noise on a user.

Embodiments of the invention provide a liquid storage container according to claim 1. Embodiments of the invention also provide a mobile air conditioner according to claim 11, which includes the above-mentioned liquid storage container. Further developments of the invention are defined by the dependent claims.

According to a first aspect of the present invention, there is provided a liquid storage container. The liquid storage container includes: a tank and a flow guide part. The tank is provided with a liquid inlet and a liquid outlet, the liquid inlet is arranged at a top of the tank and configured to allow a liquid to enter the tank, and the liquid outlet is arranged at a bottom of the tank and configured to allow the liquid to be discharged from the tank. The flow guide part is arranged in the tank, and has a bottom end connected with a bottom wall of the tank and a top end extending to the liquid inlet. A radial dimension of at least part of the flow guide part gradually increases along a direction from the top end of the flow guide part to the bottom end of the flow guide part.

The liquid storage container according to embodiments of the invention can reduce the inflow noise of condensed water and other liquids, and reduce the influence of noise on the user.

Optionally, the flow guide part includes a first flow guide section and a second flow guide section, the first flow guide section is connected to an upper part of the second flow guide section, and a radial dimension of the first flow guide section gradually increases along a direction approaching the liquid outlet, and a radial dimension of the second flow guide section is not less than the radial dimension of the first flow guide section.

Optionally, the radial dimension of the second flow guide section is larger than the radial dimension of the first flow guide section, and an annular step face is formed between the first flow guide section and the second flow guide section.

Optionally, the radial dimension of the second flow guide section remains unchanged along a direction away from the first flow guide section.

Optionally, a top of the first flow guide section is provided with a flow guide flat face arranged opposite to the liquid inlet, and a radial dimension of the flow guide flat face is smaller than a diameter of the liquid inlet.

Optionally, the flow guide part defines a cavity, the cavity penetrates through the bottom wall of the tank and forms an opening, and a cross section adjacent to the opening is not smaller than another cross section in any two cross sections of the cavity.

Optionally, the liquid inlet is provided with a flange, the flange is located inside the tank and extends along an opening edge of the liquid inlet, and is located at an outer peripheral side of the flow guide part.

Optionally, the tank is provided with an assembly groove, one end of the assembly groove penetrates through a side wall of the tank, and the other end of the assembly groove is in communication with the liquid inlet, and the assembly groove is configured to avoid a water outlet interface of a water receiving tray of the condenser and realize translational docking of the water outlet interface and the liquid inlet when translating the liquid storage container.

Optionally, the top of the tank is provided with a protrusion protruding from an upper surface of the tank, and the liquid inlet is arranged at a top side of the protrusion.

Optionally, the bottom of the tank is provided with an avoidance groove, and the liquid outlet is arranged at a groove wall of the avoidance groove at a top side.

Optionally, the tank is provided with a handle arranged at the top of the tank.

Optionally, the tank includes a first tank portion and a second tank portion, and a width dimension of the first tank portion is smaller than a width dimension of the second tank portion.

According to a second aspect of the present invention, there is provided a mobile air conditioner. The mobile air conditioner includes the liquid storage container as described in any of the above embodiments.

Optionally, the mobile air conditioner includes: a water receiving tray, an electric control box, a drainage tube, and a liquid guide tube. The water receiving tray is configured to receive condensed water generated by an evaporator. The electric control box is internally provided with a cooling cavity. The drainage tube has a first end in communication with the water receiving tray, and a second end in communication with the cooling cavity, and the drainage tube is configured to allow the condensed water to flow into the cooling cavity to cool the electric control box. The liquid guide tube has a first end in communication with the cooling cavity, and a second end in communication with the tank, and the liquid guide tube is configured to collect the condensed water in the cooling cavity into the tank.

Optionally, the liquid guide tube extends into the cooling cavity and is higher than a cavity bottom of the cooling cavity so that the condensed water in the cooling cavity can be discharged through the liquid guide tube after reaching a set height.

Optionally, the electric control box includes a radiator, and the radiator is at least partially located in the cooling cavity so that the radiator can be immersed in the condensed water.

Optionally, the electric control box includes a box body and a partition board, the partition board is arranged in the box body and divides an inner cavity of the box body into a first cavity and a second cavity, and the first cavity is located above the second cavity, and the first cavity is configured to install an electric element, and the second cavity forms the cooling cavity, the radiator passes through the partition board, and a top of the radiator extends into the first cavity, and a bottom of the radiator extends into the second cavity.

Optionally, the drainage tube passes through the partition board and extends into the cooling cavity, and part of the drainage tube is bent and extended in the first cavity.

Optionally, the mobile air conditioner includes a base plate, the base plate is provided with a slot, the slot penetrates through a side face of the mobile air conditioner, and the tank is inserted into the slot.

Optionally, the mobile air conditioner includes a base plate, the base plate is provided with a first guide part, and the tank is provided with a second guide part, and the first guide part and the second guide part are slidably assembled.

### BRIEF DESCRIPTION OF THE DRAWINGS

Fig. 1 is a rear perspective view of a liquid storage container according to an embodiment of the present invention.
Fig. 2 is a top perspective view of a liquid storage container according to an embodiment of the present invention.
Fig. 3 is a schematic sectional view of a liquid storage container at a flow guide part according to an embodiment of the present invention.
Fig. 4 is a partially enlarged view of a top of the flow guide part in Fig. 3.
Fig. 5 is a perspective view of a mobile air conditioner according to an embodiment of the present invention.
Fig. 6 is a first schematic diagram of an internal structure of a mobile air conditioner according to an embodiment of the present invention.
Fig. 7 is an assembly schematic diagram of a drainage tube, an electric control box and a liquid guide tube according to an embodiment of the present invention.
Fig. 8 is a partially enlarged schematic view at part A in Fig. 7.
Fig. 9 is a second schematic diagram of an internal structure of a mobile air conditioner according to an embodiment of the present invention.
Fig. 10 is a schematic diagram when a liquid storage container of a mobile air conditioner according to an embodiment of the present invention is pulled out.
Fig. 11 is a schematic sectional view of a mobile air conditioner at a flow guide part according to an embodiment of the present invention.
Fig. 12 is a partially enlarged schematic view at part B in Fig. 11.
Fig. 13 is a schematic sectional view of a mobile air conditioner at a liquid outlet according to an embodiment of the present invention.
Fig. 14 is a partially enlarged schematic view at part C in Fig. 13.

### List of references:

liquid storage container 100;
tank 1; liquid inlet 11; liquid outlet 12; avoidance groove 13; protrusion 14; assembly groove 15; first tank portion 16; second tank portion 17; flange 18;
flow guide part 2; first flow guide section 21; second flow guide section 22; flow guide flat face 23; annular step face 24; cavity 25;
housing 200;
water receiving tray 300;
electric control box 400; box body 401; electric element 402; radiator 403; partition board 404; first cavity 405; second cavity 406;
drainage tube 500;
liquid guide tube 600;
condenser water receiving tray 700; water outlet interface 701;
base plate 800; slot 801; boss 802; upright post 803; first slot section 8011; second slot section 8012.

### DETAILED DESCRIPTION

Hereinafter, embodiments of the present invention will be described in detail, examples of the embodiments are illustrated in the accompanying drawings. The embodiments described below with reference to the drawings are exemplary and are intended to explain the invention, but not to be construed as limiting the invention.

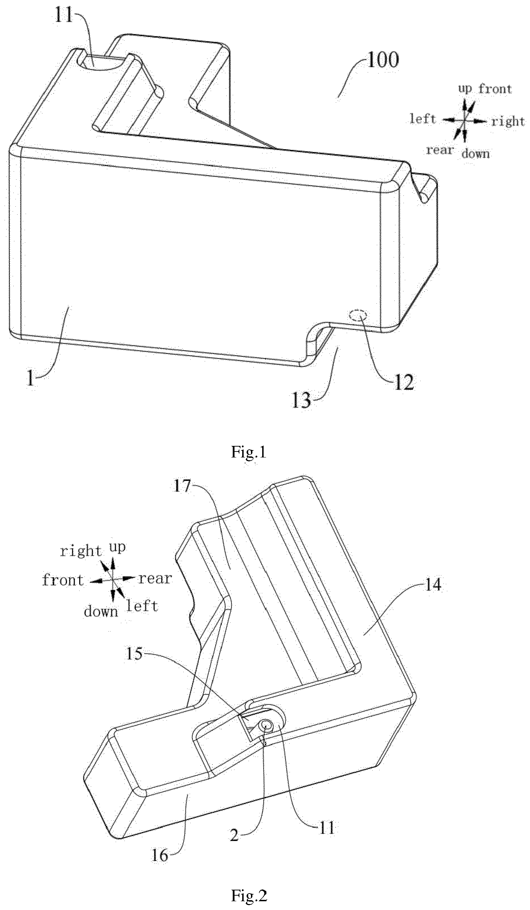

As illustrated in Figs. 1 to 3, a liquid storage container 100 according to embodiments of the present invention includes a tank 1 and a flow guide part 2. For example, the material of the liquid storage container 100 can be plastic, and the tank 1 and the flow guide part 2 can be integrally formed by injection molding. The flow guide part 2 can be located inside the tank 1.

As illustrated in Fig. 1, the tank 1 is provided with a liquid inlet 11 and a liquid outlet 12. The liquid inlet 11 is arranged at a top of the tank 1 and is configured to allow liquid to enter the tank 1. The liquid outlet 12 is arranged at a bottom of the tank 1 and is configured to allow the liquid to be discharged from the tank 1, so that the liquid can automatically drain out of the tank 1 under the action of gravity.

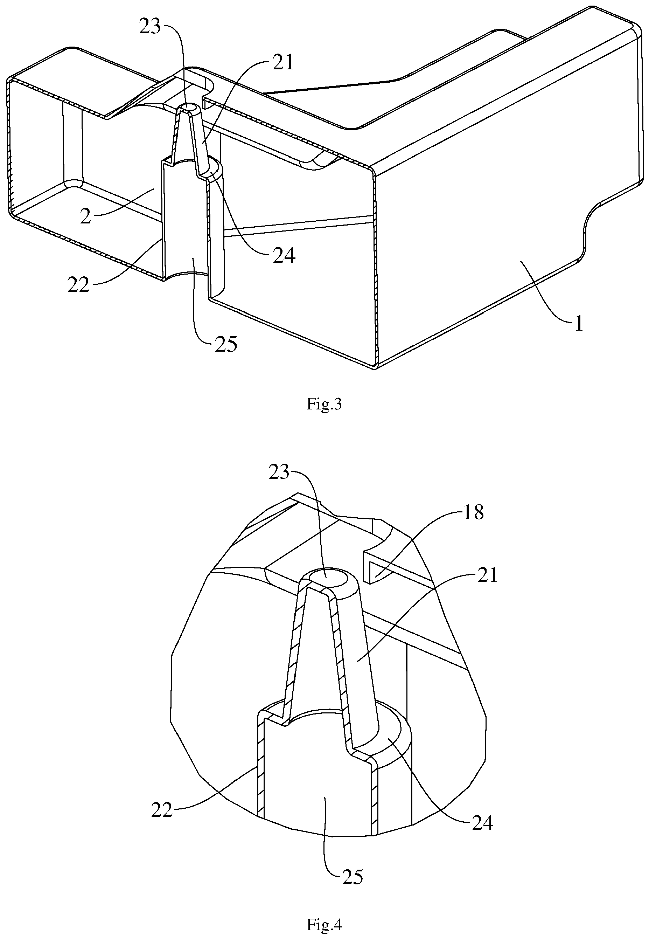

As illustrated in Fig. 3, the flow guide part 2 can be generally columnar and extend along an up-down direction. A bottom end of the flow guide part 2 can be integrally formed with a bottom wall of the tank 1, and a top end of the flow guide part 2 can extend to the liquid inlet 11. For example, the top end of the flow guide part 2 can be generally flush with a bottom of the liquid inlet 11, or it can be located below the liquid inlet 11 and at a distance from the liquid inlet 11.

A radial dimension (such as radial with respect to an axis of the flow guide part 2 between the top end and the bottom end thereof) of at least part of the flow guide part 2 gradually increases along a direction from the top end of the flow guide part 2 to the bottom end of the flow guide part 2. For example, the whole flow guide part 2 may be conical, and the radial dimension of the flow guide part 2 gradually increases from top to bottom. In some other embodiments, the radial dimension of only a part of the flow guide part 2 may gradually increase from top to bottom.

In the liquid storage container 100 according to embodiments of the invention, the liquid inlet 11 is arranged at the top, so that liquid such as condensed water can directly flow into the tank 1 under the action of gravity, and in the process of inflow, the liquid will flow along a wall of the flow guide part 2, so that the situation that the liquid generates large noise due to a large drop can be eliminated by the guidance of the flow guide part 2, the influence of noise on a user is reduced, and the comfort of using the mobile air conditioner is improved.

Secondly, the whole flow guide part 2 is a variable-diameter structure. On the one hand, this variable-diameter design can increase a surface area of the flow guide part 2, thus enhancing the flow guide efficiency; and on the other hand, this can change the flow inclination angle of the liquid flowing along the wall, and can have an effect of further buffering the flow velocity, thus further reducing noise and improving the user experience.

In some embodiments, the flow guide part 2 includes a first flow guide section 21 and a second flow guide section 22. The first flow guide section 21 is connected to an upper part of the second flow guide section 22, and a radial dimension of the first flow guide section 21 gradually increases along a direction approaching the liquid outlet 12, and a radial dimension of the second flow guide section 22 is not less than the radial dimension of the first flow guide section 21.

For example, as illustrated in Figs. 3 and 4, the flow guide part 2 can be designed in two sections, which can be divided into a first flow guide section 21 and a second flow guide section 22 according to different radial dimensions. The first flow guide section 21 and the second flow guide section 22 can be integrally formed, and the first flow guide section 21 can be located above the second flow guide section 22.

The first flow guide section 21 may be generally conical, that is, the radial dimension of the first flow guide section 21 gradually increases from top to bottom. The second flow guide section 22 may be generally cylindrical, that is, the radial dimension of the second flow guide section 22 remains unchanged from top to bottom, and the radial dimension of the second flow guide section 22 is not less than the largest radial dimension of the first flow guide section 21.

Therefore, it is verified by experiments that this structural design can reduce the occupation of the internal space of the tank 1 while reducing noise, and has both functions of noise reduction and space utilization, thus realizing the optimal design.

In some embodiments, the radial dimension of the second flow guide section 22 is larger than the radial dimension of the first flow guide section 21, and an annular step face 24 is formed between the first flow guide section 21 and the second flow guide section 22.

For example, as illustrated in Fig. 4, the radial dimension of the first flow guide section 21 is the radial dimension of the bottom of the first flow guide section 21, and the radial dimension of the second flow guide section 22 is larger than the radial dimension of the bottom of the first flow guide section 21, so that a shaft shoulder structure is formed between the first flow guide section 21 and the second flow guide section 22, that is, an annular step face 24 is formed between the first flow guide section 21 and the second flow guide section 22, and the annular step face 24 is a horizontal face.

When the liquid flows along the wall of the flow guide part 2, the annular step face 24 can further buffer the flow velocity and increase the surface area, thus further achieving noise reduction.

In some embodiments, as illustrated in Figs. 3 and 4, the top of the first flow guide section 21 is provided with a flow guide flat face 23, the flow guide flat face 23 is horizontal and arranged opposite to the liquid inlet 11, and a radial dimension of the flow guide flat face 23 is smaller than a diameter of the liquid inlet 11. The flow guide flat face 23 can play a certain role in shielding and blocking the liquid inlet 11, so that the liquid first falls on the flow guide flat face 23 as much as possible when falling, thus ensuring that the drop of the liquid drop is within a small range and avoiding the situation that the top of the first flow guide section 21 is sharp, which makes it easy for liquid to fall directly from a gap between the top tip of the flow guide part 2 and the liquid inlet 11.

In some embodiments, the flow guide part 2 is provided with a cavity 25, the cavity 25 penetrates through the bottom wall of the tank 1 and forms an opening, and in any two cross sections of the cavity 25, a cross section adjacent to the opening is not less than the other cross section.

For example, as illustrated in Fig. 3 and Fig. 4, the flow guide part 2 can be designed as a hollow structure, and the cavity 25 is located in the flow guide part 2 and its shape is generally consistent with a contour of the flow guide part 2, and a radial dimension of a lower part of the cavity 25 is not less than a radial dimension of an upper part of the cavity 15 in the up-down direction. Therefore, on the one hand, it is convenient to demould the tank 1 during injection molding, and a mold can be inserted into the cavity 25 and pulled out directly during demoulding; and on the other hand, this can reduce the use of materials and reduce the machine shaping of the tank 1, which is also beneficial to the lightweight design of the tank 1 and the subsequent pulling of the liquid storage container 100.

In some embodiments, as illustrated in Fig. 4, the liquid inlet 11 is provided with a flange 18, and the flange 18 is an inner flange. The flange 18 is located inside the tank 1 and extends along an opening edge of the liquid inlet 11, and is located at an outer peripheral side of the flow guide part 2. The design of the flange 18 can act as a barrier, and the liquid can be limited in a small spatial range, so that an annular gap between the liquid inlet 11 and the top end of the flow guide part 2 can be further reduced.

In some embodiments, the tank 1 is provided with an assembly groove 15, one end of the assembly groove 15 penetrates through a side wall of the tank 1, and the other end of assembly groove 15 is in (fluidic) communication with the liquid inlet 11. The assembly groove 15 is configured to avoid a water outlet interface 701 of a water receiving tray of the condenser and realize the translational docking of the water outlet interface 701 and the liquid inlet 11 when the liquid storage container 100 is translated.

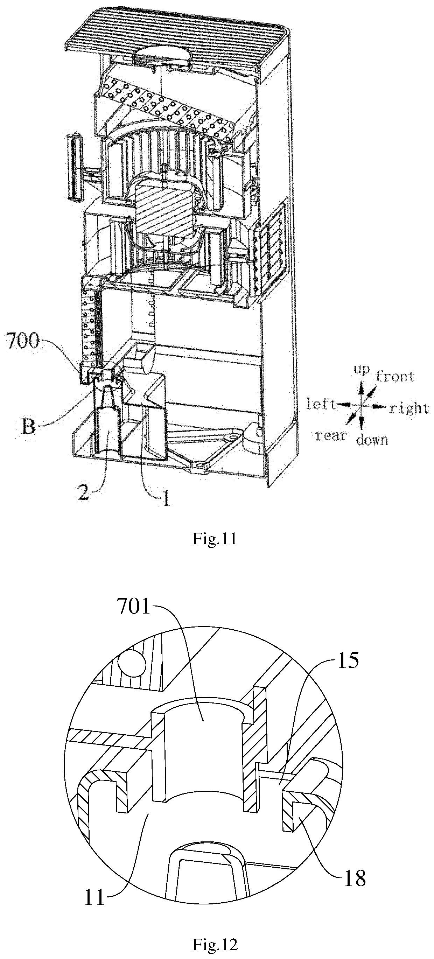

For example, as illustrated in Fig. 2, the assembly groove 15 is arranged at the top of the tank 1 and extends generally in a front-rear direction. A front end of the assembly groove 15 can penetrate through a front wall of the tank 1, and a rear end of the assembly groove 15 can communicate with the liquid inlet 11. When in use, the tank 1 can be inserted into or removed from the mobile air conditioner by translation. As illustrated in Figs. 11 and 12, the water outlet interface 701 of the condenser water receiving tray 700 of the mobile air conditioner can be inserted into the assembly groove 15, and along with the movement of the tank 1, the water outlet interface 701 can be moved to a position directly opposite to the liquid inlet 11 or separated from the liquid inlet 11 along the assembly groove 15, thus avoiding an interference of movement and facilitating an accurate positioning between the liquid inlet 11 and the water outlet interface 701.

In some embodiments, the top of the tank 1 is provided with a protrusion 14 protruding from an upper surface of the tank 1, and the liquid inlet 11 is provided at a top side of the protrusion 14. For example, as illustrated in Fig. 2, the protrusion 14 may be integrally formed at the top of the tank 1, and the protrusion 14 protrudes to an upper side of the tank 1 and forms a part of the inner cavity of the tank 1 at a lower side. The liquid inlet 11 may be arranged at the top side of the protrusion 14 and close to a front end of the protrusion 14.

On the one hand, the design of the protrusion 14 can be inserted into an internal surplus space of the mobile air conditioner, thus improving the compactness of the assembly of the liquid storage container 100, and also playing a role in limiting and restraining; and on the other hand, it can also increase the internal space of the tank 1 and improve a liquid storage capacity of the tank 1. In addition, the protrusion 14 can also play a role in raising an elevation of the liquid inlet 11 as a whole, thus facilitating the docking of the liquid inlet 11 and the water outlet interface 701, and further reducing the drop of the liquid and reducing the noise.

In some embodiments, the bottom of the tank 1 is provided with an avoidance groove 13, and the liquid outlet 12 is provided at a groove wall of the avoidance groove 13 at a top side. For example, as illustrated in Fig. 1, the avoidance groove 13 can be a step groove, and can be located at a corner of the tank 1. The avoidance groove 13 has a groove wall facing downward, and the liquid outlet 12 is arranged at the groove wall. Therefore, the liquid outlet 12 can be lifted to a height at a distance from the bottom of the tank 1, and the liquid outlet 12 can be directly opened when it is necessary to drain the liquid in the tank 1, thus avoiding the situation that the liquid outlet 12 at the bottom is easily blocked by the ground or the table top, and facilitating use.

In some embodiments, the tank 1 is provided with a handle (not illustrated), and the handle is arranged at the top of the tank 1. The arrangement of the handle is convenient for holding and moving the tank 1 in the front-rear direction.

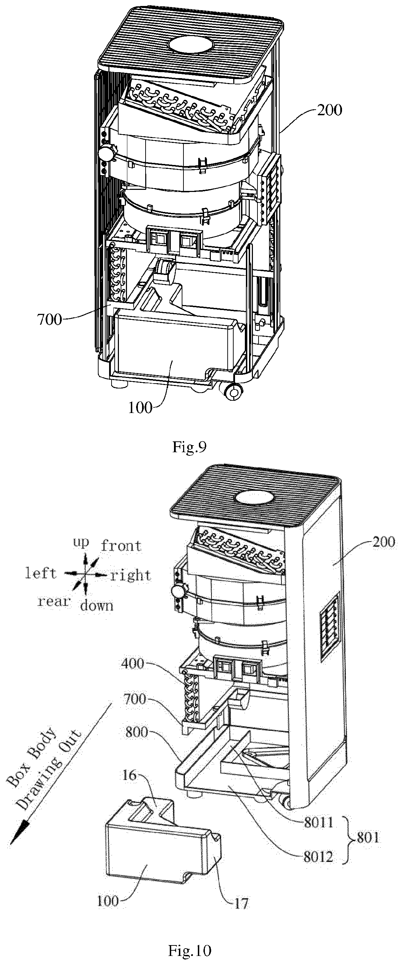

In some embodiments, the tank 1 includes a first tank portion 16 and a second tank portion 17, and a width dimension of the first tank portion 16 is smaller than a width dimension of the second tank portion 17. For example, as illustrated in Figs. 2 and 10, the first tank portion 16 and the second tank portion 17 can be integrally formed, and the first tank portion 16 can be located at a front side of the second tank portion 17, and the width dimension of the first tank portion 16 is smaller than the width dimension of the second tank portion 17 in a left-right direction. Thus, when the tank 1 is inserted into the mobile air conditioner, a step face between the first tank portion 16 and the second tank portion 17 can form a stop, so that, on the one hand, the tank 1 can be restrained and positioned, and on the other hand, an insertion depth of the tank 1 can be limited, which is convenient for the accurate docking of the liquid inlet 11 of the tank 1 and the condenser water receiving tray 700.

In some embodiments, the tank 1 is provided with an outer end face configured to face an outside of the mobile air conditioner, and the liquid outlet 12 is arranged adjacent to the outer end face. For example, as illustrated in Fig. 10, the outer end face is a side face of the tank 1 facing a withdrawal direction, specifically, a rear side face of the tank 1. The liquid outlet 12 can be arranged at the bottom of the tank 1 and close to the outer end face of the tank 1. Therefore, when it is necessary to drain the condensed water in the tank 1, a part of the tank 1 can be pulled out of the housing 200 to expose the liquid outlet 12, thus facilitating the drainage of the condensed water in the tank 1.

It should be noted that the liquid outlet 12 can be equipped with a plug and other components, and normally, the liquid outlet 12 can be sealed by the plug and the like. The plug can be removed when drainage is needed.

A mobile air conditioner according to an embodiment of the present invention will be described below.

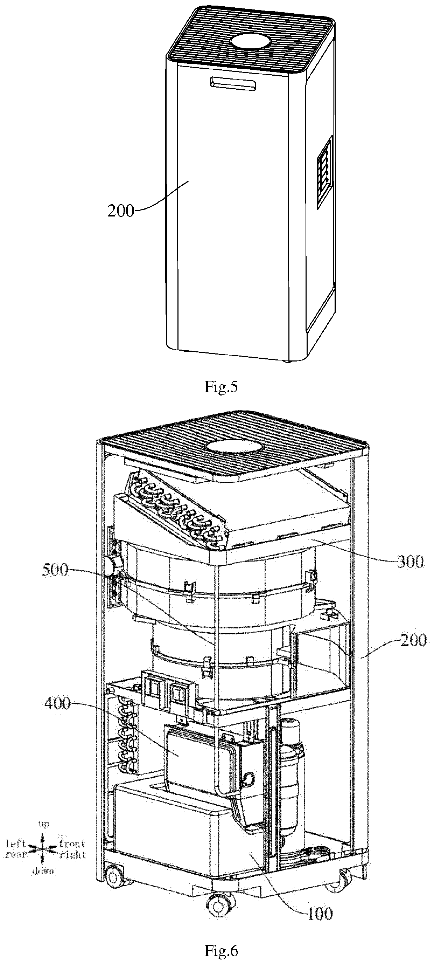

The mobile air conditioner according to an embodiment of the present invention includes a liquid storage container 100, which can be the liquid storage container 100 described in any of the above embodiments. For example, as illustrated in Fig. 5, the mobile air conditioner may include a housing 200, the housing 200 may have a cuboid shape as a whole, and a refrigeration assembly and a heating assembly may be installed in the housing 200. The refrigeration assembly may include an evaporator and a refrigeration fan, the heating assembly may include a condenser and a heating fan, and the refrigeration assembly may be located above the heating assembly.

As illustrated in Figs. 9 and 10, a condenser water receiving tray 700 can be installed below the condenser, and the condenser water receiving tray 700 is provided with a water outlet interface 701. As illustrated in Figs. 11 and 12, the water outlet interface 701 can be a short tube shape, and a part of the water outlet interface 701 can protrude from a lower surface of the condenser water receiving tray 700. When in use, the tank 1 can be located below the condenser water receiving tray 700, and the bottom of the water outlet interface 701 can extend into the liquid inlet 11 of the tank 1. Therefore, the condensed water in the condenser water receiving tray 700 can be discharged into the tank 1 through the water outlet interface 701, the need for large-capacity storage of condensed water is realized by the tank 1, the situation that excessive condensed water is easy to overflow is avoided, and the electrical protection of the mobile air conditioner is improved.

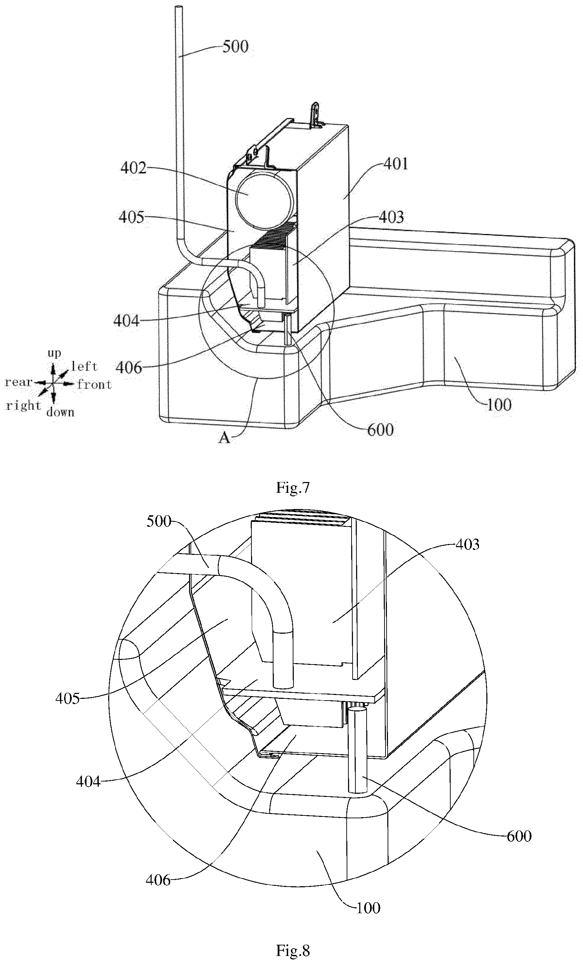

In some embodiments, the mobile air conditioner includes a water receiving tray 300, an electric control box 400, a drainage tube 500 and a liquid guide tube 600. As illustrated in Fig. 6, the water receiving tray 300 is a water receiving tray 300 of an evaporator, and the condensed water generated by the evaporator in the process of evaporation and heat absorption can be collected into the water receiving tray 300. The electric control box 400 can be a common electric control device. As illustrated in Fig. 7, some electric elements 402 such as circuit boards and switches can be installed in the electric control box 400, so that the overall operation control of the mobile air conditioner can be realized. A cooling cavity (i.e., a subsequent second cavity 406) can be provided in the electric control box 400, and the cooling cavity can be a sealed cavity and electrically isolated from the electric element 402.

As illustrated in Figs. 6 and 7, a top end of the drainage tube 500 can communicate with the water receiving tray 300, and a bottom end of the drainage tube 500 can penetrate through a box wall of the electric control box 400 and communicate with the cooling cavity. When in use, the condensed water in the water receiving tray 300 can be introduced into the cooling cavity through the drainage tube 500, and the electric control box 400 can be cooled by the condensed water, thus ensuring the operational stability of the mobile air conditioner, realizing the reuse of the condensed water, and playing the role in saving energy and reducing consumption.

As illustrated in Figs. 7 and 8, the liquid guide tube 600 can be a short circular tube, a top end of the liquid guide tube 600 can communicate with the cooling cavity, and a bottom end of the liquid guide tube 600 can communicate with the tank 1. The condensed water in the cooling cavity after heat exchange can be automatically discharged into the tank 1 through the liquid guide tube 600, and the liquid guide tube 60 is configured to collect the condensed water in the cooling cavity into the tank 1, thus facilitating the discharge and collection of the condensed water in the cooling cavity.

In some embodiments, the liquid guide tube 600 extends into the cooling cavity and is higher than a cavity bottom of the cooling cavity so that the condensed water in the cooling cavity can be discharged through the liquid guide tube 600 after reaching a set height. For example, as illustrated in Fig. 8, the liquid guide tube 600 generally extends in the up-down direction, and the top end of the liquid guide tube 600 can extend into the cooling cavity and be higher than the cavity bottom of the cooling cavity.

Therefore, under the action of gravity and hydraulic pressure, only when the height of the condensed water in the cooling cavity is flush with the top end of the liquid guide tube 600, the condensed water in the cooling cavity will flow into the tank 1 through the liquid guide tube 600. Therefore, the cooling cavity has an effect of temporarily storing condensed water, ensuring the sufficiency of heat exchange between condensed water and the electric control box 400, further ensuring the cooling effect on the electric control box 400 and improving the energy utilization rate.

In some embodiments, the electric control box 400 includes a radiator 403, and the radiator 403 is at least partially located in the cooling cavity so that the radiator 403 can be immersed in the condensed water. For example, as illustrated in Figs. 7 and 8, the radiator 403 can be a radiating fin, and the radiator 403 can be connected with the electric element 402, so that the heat of the electric element 402 can be quickly dissipated by the radiator 403. The cooling cavity can be arranged at a bottom of the electric control box 400, and a bottom of the radiator 403 can extend into the cooling cavity. Thus, the radiator 403 can be cooled by the condensed water in the cooling cavity, which makes the cooling more targeted and is beneficial to improving the efficiency and effect of heat exchange and cooling.

In some embodiments, as illustrated in Figs. 7 and 8, the electric control box 400 includes a box body 401 and a partition board 404. The partition board 404 is arranged in the box body 401, and can be arranged generally horizontally, and can divide an inner cavity of the box body 401 into a first cavity 405 and a second cavity 406. The first cavity 405 is located above the second cavity 406, and the electric element 402 can be installed in the first cavity 405, and the second cavity 406 forms the cooling cavity.

The partition board 404 can be provided with a through hole, and the radiator 403 can pass through the partition board 404 through the through hole, and a top of the radiator 403 can extend into the first cavity 405, and a bottom of the radiator 403 can extend into the second cavity 406. Therefore, the condensate water is electrically isolated from the electric element 402, and the electrical protection of the electric control box 400 is improved.

In some embodiments, the drainage tube 500 passes through the partition board 404 and extends into the cooling cavity, and part of the drainage tube 500 is bent and extended in the first cavity 405. For example, as illustrated in Fig. 8, the drainage tube 500 can penetrate into the box body 401 through a rear box wall of the electric control box 400, and then can be bent downward and pass through the partition board 404. By bending and extending the drainage tube 500 in the first cavity 405, the condensed water in the drainage tube 500 can exchange heat with the radiation heat in the first cavity 405, which can improve the heat exchange efficiency.

In some embodiments, the mobile air conditioner includes a base plate 800, and the base plate 800 is provided with a slot 801. The slot 801 penetrates through a side face of the mobile air conditioner, and the tank 1 is inserted into the slot 801. For example, as illustrated in Figs. 9 and 10, the slot 801 generally extends in the front-rear direction, and a rear end of the slot 801 can penetrate a rear side wall of the mobile air conditioner and form an opening.

As illustrated in Fig. 10, according to different width dimensions, the slot 801 can be divided into two parts in the front-rear direction, namely a first slot section 8011 and a second slot section 8012. A width dimension (in the left-right direction) of the first slot section 8011 can be smaller than a width dimension of the second slot section 8012, and the first slot section 8011 can be located at a front side of the second slot section 8012, so that the whole slot 801 can be presented as an "L" shape.

As illustrated in Fig. 10, the tank 1 can also be divided into two parts in the front-rear direction according to different width dimensions, namely a first tank portion 16 and a second tank portion 17. The first tank portion 16 is located at a front side of the second tank portion 17, and a width dimension (in the left-right direction) of the first tank portion 16 can be smaller than a width dimension of the second tank portion 17.

When the tank 1 is assembled into the housing 200, the first tank portion 16 can be inserted into the first slot section 8011 and the second tank portion 17 can be inserted into the second slot section 8012. By the stop of the step face between the first slot section 8011 and the second slot section 8012, an insertion depth of the tank 1 can be limited, thus further ensuring the accurate docking between the drainage interface and the liquid inlet 11, and also playing a role in restricting the tank 1 in the front-rear direction and the left-right direction.

In some embodiments, the mobile air conditioner includes a base plate 800, the base plate 800 is provided with a first guide part, the tank 1 is provided with a second guide part, and the first guide part and the second guide part are slidably assembled.

For example, the first guide part can be arranged on the base plate 800, and the first guide part can be a guide rail; the second guide part can be arranged at the bottom of the tank 1, and the second guide part can be a guide groove. Both the first guide part and the second guide part may extend in the front-rear direction. In the process of moving the tank 1, the first guide part and the second guide part can keep the guided sliding fit, so that the assembly accuracy of the tank 1 can be further enhanced, and the friction between the tank 1 and the base plate 800 can be reduced, which is convenient for the tank 1 to slide in the front-rear direction.

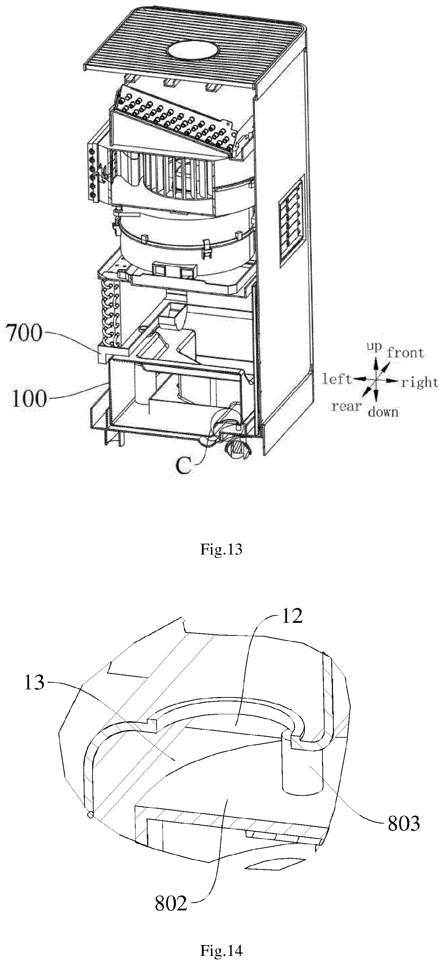

In some embodiments, the base plate 800 is provided with a boss 802, and the boss 802 fits in the avoidance groove 13. For example, as illustrated in Figs. 13 and 14, the boss 802 may be integrally formed on an upper side of the base plate 800, and the boss 802 may be located at a corner of the base plate 800. The avoidance groove 13 can be located at a bottom corner of the tank 1. When the tank 1 is assembled into the housing 200, the boss 802 can be embedded in the avoidance groove 13, so that the restraining and limiting effect on the tank 1 can be enhanced.

It should be noted that a groove will be formed at a bottom of the base plate 800 corresponding to the boss 802, and a roller of the base plate 800 can be installed in the groove. Thus, on the one hand, part of the roller can be hidden, and the compactness of assembly can be improved; and on the other hand, the structural strength of the installation position of the roller can be enhanced, thus meeting the use requirements.

In some embodiments, as illustrated in Fig. 14, an upright post 803 is arranged on the boss 802, and the upright post 803 is configured to abut against the groove wall of the avoidance groove 13 to support the tank 1. The upright post 803 can be generally cylindrical, and the upright post 803 can be integrally formed at a top of the boss 802 and can extend in the up-and-down direction. When the tank 1 is assembled into the housing 200, the upright post 803 can be supported at the bottom of the tank 1, thus ensuring the structural stability of the assembly of the tank 1. Secondly, the situation that the boss 802 directly contacts with the tank 1 can be avoided, thereby reducing the stress area and facilitating the sliding of the tank 1 in the front-rear direction.

In the description of the present invention, it should be understood that the orientation or positional relationship indicated by the terms center, longitudinal, transverse, length, width, thickness, up, down, front, rear, left, right, vertical, horizontal, top, bottom, inner, outer, clockwise, counterclockwise, axial, radial and circumferential is based on the orientation or positional relationship illustrated in the attached drawings, which is only for the convenience of describing the present invention and simplifying the description, and does not indicate or imply that the referred devices or elements must have a specific orientation, be constructed and operated in a specific orientation, so it cannot be understood as limiting the present invention.

In addition, the terms "first" and "second" are only used for descriptive purposes, and cannot be understood as indicating or implying relative importance or implicitly indicating the number of indicated technical features. Therefore, the features defined as "first" and "second" can explicitly or implicitly comprise at least one of these features. In the description of the present invention, "a plurality of" means at least two, such as two, three, etc., unless otherwise specifically defined.

In the present invention, unless otherwise specified and limited, the terms such as "installed", "connected", "coupled" and "fixed" and variations thereof should be appreciated broadly, for example, it could refer to fixed connection, detachable connection or integrated connection, as well as mechanically connected, electrically connected or communicatively connected. It can also refer to directly connected or indirectly connected through an intermediary, as well as the internal connection of two elements or the interaction between two elements, unless expressly described otherwise. It would be appreciated by those skilled in the art that the specific meanings of the above terms in this disclosure can be understood according to specific situations.

In the present invention, unless otherwise specified and limited, a first feature being "above" or "below" a second feature can be in direct contact or indirectly through an intermediary. Moreover, the terms "above", "on" and "on top of" may mean that the first feature is directly above or obliquely above the second feature, or simply mean that the horizontal height of the first feature is higher than the second feature. The terms "below", "under" and "on bottom of" can mean that the first feature is directly below or obliquely below the second feature, or can simply mean that the horizontal height of the first feature is smaller than the second feature.

Reference throughout this specification to "an embodiment" , "some embodiments", "an example", "a specific example", or "some examples" means that a particular feature, structure, material, or characteristic described in connection with the embodiment or example is comprised in at least one embodiment or example of the present disclosure. In this specification, the schematic expressions of the above terms are not necessarily aimed at the same embodiment or example. Moreover, the specific features, structures, materials or characteristics described may be combined in any one or more embodiments or examples in a suitable manner. In addition, those skilled in the art can combine and combine different embodiments or examples and features of different embodiments or examples described in this specification without contradicting each other.

## Claims

1. A liquid storage container (100), comprising:
a tank (1) provided with a liquid inlet (11) and a liquid outlet (12), the liquid inlet (11) being arranged at a top of the tank (1) and configured to allow liquid to enter the tank (1), the liquid outlet (12) being arranged at a bottom of the tank (1) and configured to allow the liquid to be discharged from the tank (1); and
a flow guide part (2) arranged in the tank (1), the flow guide part (2) having a bottom end connected with a bottom wall of the tank (1) and a top end extending to the liquid inlet (11), a radial dimension of at least part of the flow guide part (2) gradually increases along a direction from the top end of the flow guide part (2) to the bottom end of the flow guide part (2).

2. The liquid storage container (100) according to claim 1, wherein the flow guide part (2) comprises a first flow guide section (21) and a second flow guide section (22), the first flow guide section (21) is connected to an upper part of the second flow guide section (22), a radial dimension of the first flow guide section (21) gradually increases along a direction approaching the liquid outlet (12), and a radial dimension of the second flow guide section (22) is not less than the radial dimension of the first flow guide section (21).

3. The liquid storage container (100) according to claim 2, wherein the radial dimension of the second flow guide section (22) is larger than the radial dimension of the first flow guide section (21), and an annular step face (24) is formed between the first flow guide section (21) and the second flow guide section (22);
or, wherein the radial dimension of the second flow guide section (22) remains unchanged along a direction away from the first flow guide section (21);
or, wherein a top of the first flow guide section (21) is provided with a flow guide flat face (23) arranged opposite to the liquid inlet (11), and a radial dimension of the flow guide flat face (23) is smaller than a diameter of the liquid inlet (11).

4. The liquid storage container (100) according to any one of claims 1 to 3, wherein the flow guide part (2) is provided with a cavity (25), the cavity (25) penetrates through a bottom wall of the tank (1) and forms an opening, and in any two cross sections of the cavity (25), a cross section adjacent to the opening is not smaller than another cross section.

5. The liquid storage container (100) according to any one of claims 1 to 4, wherein the liquid inlet (11) is provided with a flange (18), the flange (18) is located inside the tank (1) and extends along an opening edge of the liquid inlet (11), and is located at an outer peripheral side of the flow guide part (2).

6. The liquid storage container (100) according to any one of claims 1 to 5, wherein the tank (1) is provided with an assembly groove (15), the assembly groove (15) has a first end penetrating through a side wall of the tank (1), and a second end in communication with the liquid inlet (11), and the assembly groove (15) is configured to avoid a water outlet interface (701) of a water receiving tray (700) of a condenser and realize translational docking of the water outlet interface (701) and the liquid inlet (11) when translating the liquid storage container (100).

7. The liquid storage container (100) according to any one of claims 1 to 6, wherein the top of the tank (1) is provided with a protrusion (14) protruding from an upper surface of the tank (1), and the liquid inlet (11) is arranged at a top side of the protrusion (14).

8. The liquid storage container (100) according to any one of claims 1 to 7, wherein the bottom of the tank (1) is provided with an avoidance groove (13), and the liquid outlet (12) is arranged at a groove wall of the avoidance groove (13) at a top side.

9. The liquid storage container (100) according to any one of claims 1 to 8, wherein the tank (1) is provided with a handle arranged at the top of the tank (1).

10. The liquid storage container (100) according to any one of claims 1 to 9, wherein the tank (1) comprises a first tank portion (16) and a second tank portion (17), and a width dimension of the first tank portion (16) is smaller than a width dimension of the second tank portion (17).

11. A mobile air conditioner, comprising a liquid storage container (100) according to any one of claims 1-10.

12. The mobile air conditioner according to claim 11, comprising:
a water receiving tray (300) configured to receive condensed water generated by an evaporator;
an electric control box (400) provided with a cooling cavity;
a drainage tube (500) having a first end in communication with the water receiving tray (300), and a second end in communication with the cooling cavity, and the drainage tube (500) being configured to allow the condensed water to flow into the cooling cavity to cool the electric control box (400); and
a liquid guide tube (600) having a first end in communication with the cooling cavity, and a second end in communication with the tank (1), and the liquid guide tube (600) being configured to collect the condensed water in the cooling cavity into the tank (1).

13. The mobile air conditioner according to claim 12, wherein the liquid guide tube (600) extends into the cooling cavity and is higher than a cavity bottom of the cooling cavity such that the condensed water in the cooling cavity can be discharged through the liquid guide tube (600) after reaching a set height.

14. The mobile air conditioner according to claim 12 or 13, wherein the electric control box (400) comprises a radiator (403), and the radiator (403) is at least partially located in the cooling cavity such that the radiator (403) can be immersed in the condensed water;
preferably, wherein the electric control box (400) comprises a box body (401) and a partition board (404), and the partition board (404) is arranged in the box body (401) and divides an inner cavity of the box body (401) into a first cavity (405) and a second cavity (406); the first cavity (405) is located above the second cavity (406), and the first cavity (405) is configured to install an electric element (402), and the second cavity (406) forms the cooling cavity; the radiator (403) passes through the partition board (404), a top of the radiator (403) extends into the first cavity (405), and a bottom of the radiator (403) extends into the second cavity (406);
preferably, wherein the drainage tube (500) passes through the partition board (404) and extends into the cooling cavity, and part of the drainage tube (500) is bent and extended in the first cavity (405).

15. The mobile air conditioner according to any one of claims 11 to 14, comprising a base plate (800),
wherein the base plate (800) is provided with a slot (801), the slot (801) penetrates through a side face of the mobile air conditioner, and the tank (1) is inserted into the slot (801);
or, wherein the base plate (800) is provided with a first guide part, the tank (1) is provided with a second guide part, and the first guide part and the second guide part are slidably assembled.
